# EUROPEAN PATENT SPECIFICATION

(11) **EP 1 759 420 B1**
(45) Date of publication and mention of the grant of the patent: **12.05.2010**
(21) Application number: 05744765.8
(22) Date of filing: 06.06.2005
(51) Int. Cl.: H01L 29/786, H01L 29/417, H01L 21/336, H01L 29/45

(54) **SEMICONDUCTOR ON INSULATOR SEMICONDUCTOR DEVICE AND METHOD OF MANUFACTURE**
HALBLEITER-AUF-ISOLATOR-HALBLEITERBAUELEMENT UND HERSTELLUNGSVERFAHREN
SEMI-CONDUCTEUR SUR DISPOSITIF A SEMI-CONDUCTEURS DE TYPE ISOLATEUR AINSI QUE PROCEDE DE FABRICATION ASSOCIE

(30) Priority: 12.06.2004 GB 0413133
(43) Date of publication of application: 07.03.2007
(73) Proprietor: NXP B.V., 5656 AG Eindhoven (NL)
(72) Inventor: SURDEANU, Radu c/o Philips Intel. Prop. & Standards, Redhill Surrey RH1 5HA (GB); DOORNBOS, Gerben c/o Philips Intel. Prop. & Standards, Redhill Surrey RH1 5HA (GB); PONOMAREV, Youri c/o Philips Intel. Prop. & Standards, Redhill Surrey RH1 5HA (GB); LOO, Josine c/o Philips Intel. Prop. & Standards, Redhill Surrey RH1 5HA (GB)
(74) Representative: Williamson, Paul Lewis
(86) International application number: PCT/IB2005/051832
(87) International publication number: WO 2005/122275

(56) References cited:
- JP-A- 61 226 957
- US-A- 5 449 642
- US-A- 5 818 070
- US-A- 5 818 070
- US-A- 5 846 855
- US-A1- 2002 036 320
- US-A1- 2003 006 462
- US-A1- 2003 042 547
- US-A1- 2003 122 164
- US-A1- 2003 141 553
- US-B1- 6 313 008
- US-B1- 6 395 587
- US-B1- 6 413 829
- US-B1- 6 514 829
- AHMED S S ET AL: "A planar 6.3 nm thin-body SOI MOSFET using tunnel epitaxy and nitrided gate oxides" PROCEEDINGS OF THE 15TH. BIENNIAL UNIVERSITY/GOVERNMENT/INDUSTRY MICROELECTRONICS. UGIM 2003. BOISE, ID, JUNE 30 - JULY 2, 2003, UNIVERSITY/GOVERNMENT/INDUSTRY MICROELECTRONICS SYMPOSIUM. (UGIM), NEW YORK, NY : IEEE, US, 30 June 2003 (2003-06-30), pages 280-283, XP010655078 ISBN: 0-7803-7972-1
- PATENT ABSTRACTS OF JAPAN vol. 011, no. 070 (E-485), 3 March 1987 (1987-03-03) -& JP 61 226957 A (HITACHI LTD), 8 October 1986 (1986-10-08)
- "VERTICAL SOURCE/DRAIN CONTACTS FOR SOI BASED MOSFETS" IBM TECHNICAL DISCLOSURE BULLETIN, IBM CORP. NEW YORK, US, vol. 35, no. 2, 1 July 1992 (1992-07-01), pages 468-469, XP000313361 ISSN: 0018-8689

## Description

The invention relates to a semiconductor on insulator (SOI) type semiconductor device, for example a double gated SOI device or a fully depleted semiconductor on insulator device (FD-SOI).

SOI technology has a number of advantages in specialized applications as has been realized for some time. More recently, it has been realized that SOI technology may also offer solutions to problems faced in more general applications of insulated gate transistors and in particular in scaling devices to achieve lower sizes.

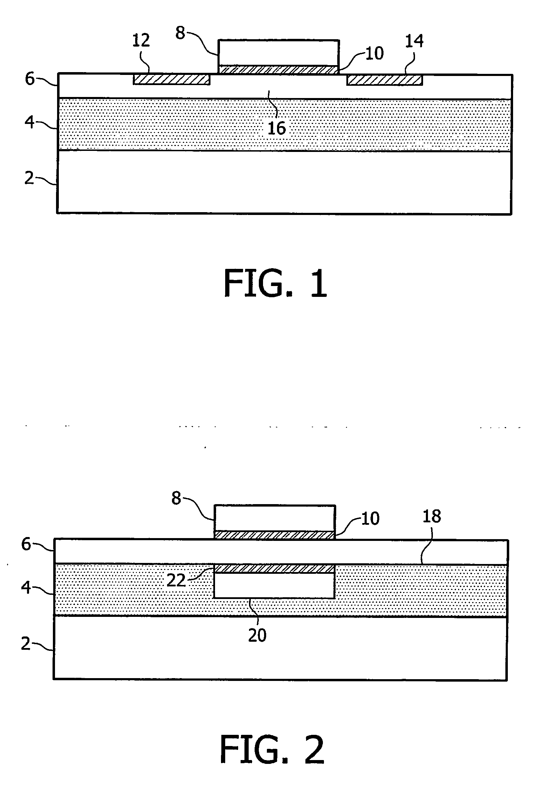

In the SOI device illustrated in Figure 1, a layer of semiconductor 6 is provided over insulator 4 on a substrate 2, normally of silicon. A gate 8 is provided over the thin semiconductor layer insulated from it by gate insulator 10, and implanted source 12 and drain 14 electrodes provide the contacts. The semiconductor 16 between source and drain 12, 14 acts as a body. Conduction through the body between source and drain 12, 14 is controlled by the gate 8.

A particularly beneficial form of SOI technology is known as fully depleted SOI (FD-SOI). In this approach, the semiconductor layer 6 is very thin so that it is fully depleted. Electron transport between source and drain occurs only in the thin channel adjacent to the gate. FD-SOI has improved electrical characteristics, allowing optimization for high temperature, low voltage and low power applications.

A major challenge for FD-SOI is the manufacturing technology which is difficult. There is a need for improved processes to manufacture such devices.

A development of SOI technology is the double gated SOI structure (DG-SOI) in which a further insulated gate is provided below the semiconductor layer 6.

Conventionally, the manufacture of FD-SOI and DG-SOI devices use conventional complementary metal oxide semiconductor (CMOS) processing steps. The source, body and drain are defined using ion implantation and activation annealing. Unfortunately, in thin SOI devices such as FD-SOI and DG-SOI, the resulting sheet resistance and contact resistance are rather high. As a consequence, the series resistance of the transistor is high leading to sub-optimal performance of the transistor.

US2003/0042547 describes a metal source and drain MOS transistor and a method for making such a transistor. The described method includes providing a SOI substrate on which is formed a transistor grid on a thin surface layer. The method also includes performing an implantation process to form doped regions on each side of the grid. After the implantation, insulating spacers are formed on the sides of the grid and a second implantation step is performed, the purpose of which is to obtain a material that can be etched selectively with respect to the doped regions not affected by the second implantation. After selective isotropic chemical etching applied to eliminate the second implanted regions, metal silicide contact layers are formed on the three sides of the source and drain extension regions.

US6514829 describes a method of fabricating an integrated circuit forming abrupt source/drain junctions. The method includes implantation steps to amorphize a thin film semiconductor layer and to provide source/drain dopant implants. The method also includes a rapid thermal anneal to re-crystalise dopants within the amorphize region.

There is thus a need for a new transistor structure with a reduced series resistance and a method of making it.

Aspects of the invention are defined in the accompanying claims.

According to an aspect of the invention, there is provided a method of making a transistor, the method comprising:
providing a semiconductor on insulator substrate having a semiconductor layer above insulator;
defining an upper insulated gate above the semiconductor layer;
implanting an amorphizing implant and dopant to create doped, amorphized regions in the semiconductor layer except where the semiconductor layer is protected by the gate, thereby leaving a single crystalline body region under the upper insulated gate;
annealing the structure to regrow part of the doped, amorphous regions starting from the single crystalline body region to form single crystal activated source and drain regions; and
forming metallic contacts in contact with the activated source and drain regions by replacing the remaining parts of the doped amorphous regions of the semiconductor layer with metal, wherein said replacing comprises:
   removing the remaining parts of the doped, amorphous regions of the semiconductor payer using a selective etch, wherein said selective etch selectively removes the doped amorphous regions of the semiconductor layer without removing said single crystal activated source and drain regions; and then
   depositing said metallic contacts.

The activated regions have an abrupt junction with the channel which can significantly reduce leakage in the off-state of the semiconductor device.

The process is a low temperature process and accordingly integrateable into advanced CMOS flows.

The step of forming metallic contacts from the source and drain regions incudes removing the amorphous part of the semiconductor layer using a selective etch; and depositing metallic contacts onto the source and drain regions. Such metallic contacts can have a much lower resistance than prior art approaches with the top layer of a silicon silicided.

The step of annealing the structure to regrow part of the doped amorphous regions starting from the single crystalline body region may be carried out at a temperature from 500°C to 750°C.

The annealing step may be carried out for a time to regrow from 3nm to 10nm of single crystal semiconductor.

Experiments suggest that the optimal regrowth is L_{gate} /6 plus from 1 to 3nm, where L_{gata} is the length of the gate.

The step of implanting an amorphizing implant into the semiconductor layer may be carried out at a tilt of between 5° and 30°, preferably between 7° and 30° to get sufficient effect. Preferably, the tilt angle should be such that the overlap between amorphised semiconductor and the gate is about L_{gate} /6,

Alternatively, a single amorphizing and doping step may be used.

The semiconductor is preferably silicon.

The use of metallic contact regions together with activated source and drain regions instead of the conventional silicided doped silicon layers can lead to a dramatic reduction in series resistance, one of the major problems for thin-body semiconductor devices.

A transistor made in according with this invention may further include lower insulated gate below the channel region below the first planar surface, i.e. the transistor may be a double gated structure.

The doping in the activated regions may be at least 10¹⁹ cm⁻³ preferably at least 10²⁰ cm⁻³ and in particularly preferred embodiments at least 3x10²⁰ cm⁻³. By providing such highly doped regions, the effect of the Schottky barrier on current flow between the metallic contact regions and the activated semiconductor regions is minimized.

For a better understanding of the invention, embodiments will now be described, purely by way of example, with reference to the accompanying drawings in which:
Figure 1 shows a prior art SOI structure;
Figure 2 shows a double gated intermediate structure;
Figures 3 and 4 show intermediate steps in a first embodiment of a method according to the invention;
Figure 5 shows a device according to the first embodiment of the invention;
Figures 6 and 7 show intermediate steps for making a transistor; and
Figure 8 shows a transistor made according to the method shown in Figures 6 and 7.

Note that the Figures are schematic and not to scale.

The method according to the invention starts by providing a structure with a thin layer of silicon 6 provided over insulator 4 on a substrate 2, also of silicon. An upper gate 8 is provided over the thin silicon layer insulated from it by gate insulator 10. A lower gate 20 is provided below the layer of silicon 6, likewise insulated from it by gate insulator 22, as illustrated in Figure 2. Such structures are known to those skilled in the art and so their manufacture will not be described further.

A junction implant is then carried out to dope the source and drain regions 24,26. The doping should be heavy (at least 10¹⁹ cm⁻³) and for the full benefit of the invention the doping should be at least 10²⁰ cm⁻³. The doping can be either n- or p- type depending on whether an n-type or p-type transistor is being fabricated. The dopant may be B, In etc for a P-type transistor or P, As or Sb for an N-type transistor.

An anneal step follows, which can be a high ramp-rate spike, flash rapid thermal anneal or a sub-melt low-fluence laser anneal. The anneal step ensures the high level activation of the junction and a small diffusion under the gate.

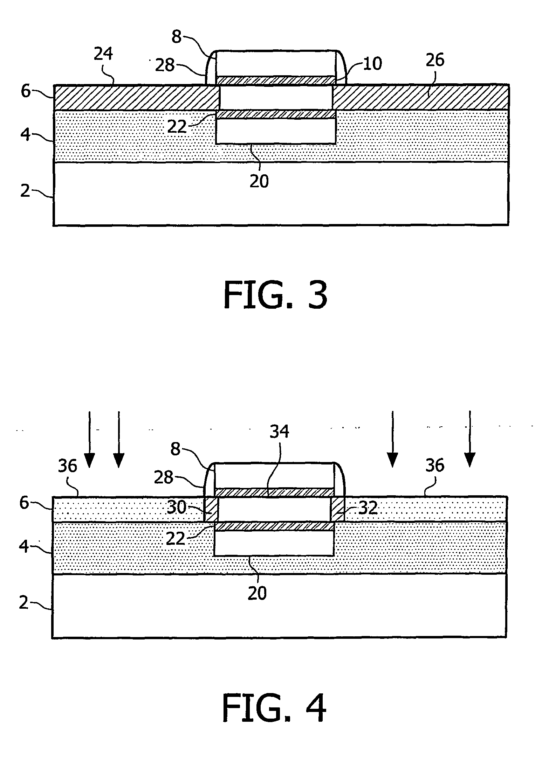

Offset spacers 28 are now fabricated on the upper gate 8, using methods known in the art, such as depositing the material of the spacer on the whole surface and then etching the material away using an anisotropic etch to remove the material from the horizontal surface leaving the material just on the sidewalls of the gate to form the spacers 28. The spacers may be of oxide and/or nitride. The width of the spacers is preferably less than 5nm. This results in the structure of Figure 3.

An amorphizing implant is then performed amorphizing the full thickness of the silicon layer 6 except where protected by the spacers 28 and upper gate 8, leaving amorphous silicon regions 36 in the regions affected by the amorphizing. The implant can be of species such as Ge, As, Sb or In implanted at a dose and an energy to render the full thickness of silicon layer 6 amorphous. This step leaves activated source and drain regions 30, 32 under the spacers and a body region 34 between the two, as shown in Figure 4.

Next, a selective etch is performed to remove the amorphous silicon regions 36, but not the crystalline regions 30,32,34 or the spacers. Such etches are known. For example, HF may be used if nitride spacers are used, or H₃PO₄ may be used if oxide spacers are used

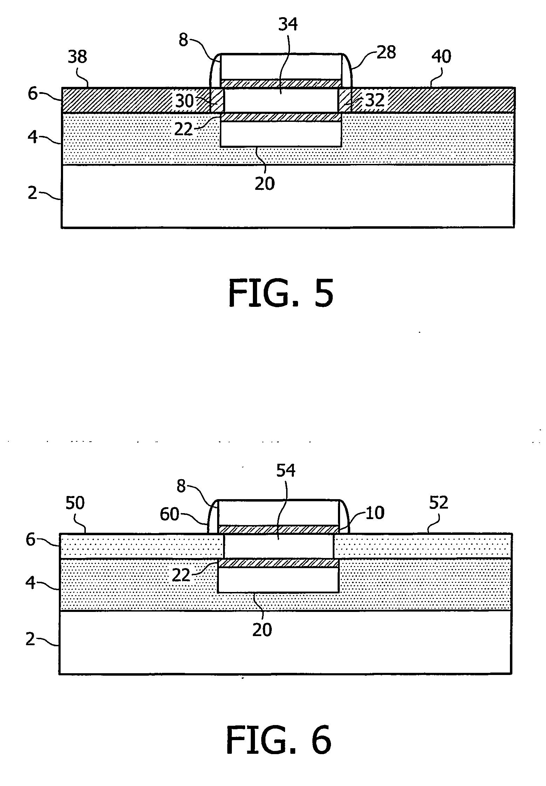

Metal is then deposited selectively to form source and drain contact regions 38,40 to replace the removed amorphous silicon as shown in Figure 5.

Processing then continues to finish the device as in conventional processes.

The method is easy to integrate in a CMOS flow and leads to a transistor with a highly reduced resistance. Although at first sight the Schottky barrier between the contact regions 38, 40 and the activated source and drain regions 30, 32, would seem to be highly disadvantageous, the activated regions can be highly doped and this reduces the effect of the barrier to reduce the overall resistance

A second embodiment of a method according to the invention starts with a device at the stage of Figure 2.

Next, an initial amorphisation step is performed to create amorphous regions 50,52. The same species may be used as in the first embodiment, for example Ge, As, Sb or In, but in the second embodiment the implantation is done at a tilt. The tilt angle is selected so that the amorphous region overlaps the gate by about 1/6 of the gate length, leaving central region 54 between the amorphous regions 50, 52.

Next, dopant is implanted into the amorphous regions 50,52. The dopant may be B, In etc for a P-type transistor or P, As or Sb for an N-type transistor. This leads to the structure shown in Figure 6.

In alternative embodiments a single implantation step can be used instead of the amorphisation and dopant implantation steps.

Next, a low temperature Solid Phase Epitaxy Regrowth (SPER) anneal step is performed, at a typical temperature of 500°C to 750°C. Single crystal semiconductor now grows outwards from the central region 54, forming doped single crystal source and drain regions 56, 58. The regrowth time is tuned so that only a few nm of regrowth is obtained, typically 3-10nm. Simulations suggest that the optimum regrowth depends on the gate length L_{g}, and should be of order L_{g} / 6 plus from 1 to 3nm.

After this step, a highly abrupt (<2nm /decade), highly active (>3x10²⁰ cm⁻³) small junction is obtained between the doped single crystal regions 56,58 and the central channel region 54.

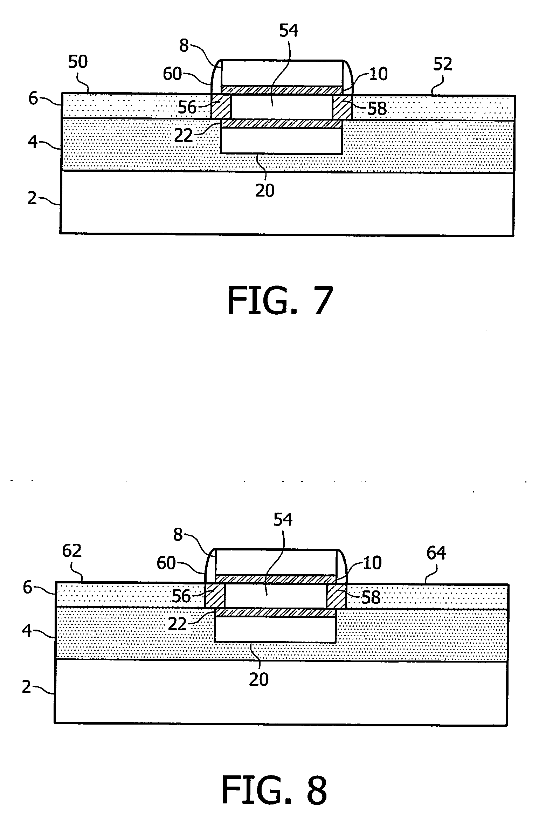

Thin spacers 60 are then fabricated, leaving the device as shown in Figure 7.

For the purposes of illustration only, a silicidation process may then take place, by depositing metal and siliciding in separate steps or in a single step, so that the whole thickness of the retaining amorphous silicon is consumed. This results in silicide source and drain contact regions 62,64. The resulting structure is shown in Figure 7, which differs from that shown in Figure 5 in that the metal of Figure 5 is replaced by the silicide in Figure 8.

Due to the suicide process, dopants in the amorphous silicon will be pushed into the activated single crystal regions 56,58, further enhancing then doping in those regions improving device properties.

The structure can deliver great improvement of current drive due to a dramatic reduction of series resistance. The method delivers a highly abrupt junction between channel and metal thereby greatly improving the leakage current in the off-state by up to two orders of magnitude.

However, according to the second embodiment, processing instead continues as in the first embodiment to replace the amorphous regions with metal, leading to a structure similar to that of Figure 4.

Although the above embodiments have been described using silicon as the semiconductor, the invention is applicable to other semiconductors such as GaAs, InP, InSb, etc., with the appropriate choice of dopants, for example Zn and Mn.

The above embodiments are double gated structures. The invention is equally applicable to FD-SOI structures only with a single gate by simply omitting the lower gate 20 and gate insulator 22 from the structures.

## Claims

1. A method of making a transistor, the method comprising:
providing a semiconductor on insulator substrate having a semiconductor layer (6) above insulator (4);
defining an upper insulated gate (8) above the semiconductor layer (6);
implanting an amorphizing implant and dopant to create doped, amorphized regions in the semiconductor layer except where the semiconductor layer (6) is protected by the gate (8), thereby leaving a single crystalline body region (54) under the upper insulated gate (8);
annealing the structure to regrow part of the doped, amorphous regions starting from the singe crystalline body region (54) to form single crystal activated source and drain regions (56,58); and
forming metallic contacts (62,64) in contact with the activated source and drain regions (56,58) by replacing the remaining parts of the doped, amorphous regions of the semiconductor layer (6) with metal, wherein said replacing comprises:
removing the remaining parts of the doped, amorphous regions of the semiconductor layer (6) using a selective etch, wherein said selective etch selectively removes the doped, amorphous regions of the semiconductor layer (6) without removing said single crystal activated source and drain regions (56,58); and then
depositing said metallic contacts (38,40),

2. A method according to claim 1, wherein the step of annealing the structure to regrow part of the doped, amorphous regions starting from the single crystalline body region is carried out at a temperature from 500°C to 7.50°C.

3. A method according to claim 1 or claim 2, wherein said implanting an amorphizing implant and dopant comprises:
implanting an amorphizing implant into the semiconductor layer (6); followed by
implanting a dopant into the semiconductor layer (6).

4. A method according to claim 3, wherein said implanting an amorphizing implant into the semiconductor layer (6) is carried out at a tilt of between 5° and 30°.

5. A method according to any of claims 1 to 4, wherein the annealing step is carried out for a time to regrow a length from 3nm to 10nm of single crystal activated source region (56) and of single crystal activated drain region (58).

## Patentansprüche

1. Verfahren zur Fertigung eines Transistors, wobei das Verfahren umfasst:
Bereitstellen eines Halbleiter-auf-Isolator-Substrats, das eine Halbleiterschicht (6) über einem Isolator (4) aufweist;
Definieren eines oberen isolierten Gates (8) über der Halbleiterschicht (6);
Implantieren eines amorphisierenden Implantierungsstoffes und eines Dotierungsstoffes, um dotierte, amorphisierte Gebiete in der Halbleiterschicht zu erzeugen, mit Ausnahme dort, wo die Halbleiterschicht (6) durch das Gate (8) geschützt ist, um somit ein einkristallines Körpergebiet (54) unter dem oberen isolierten Gate (8) zu belassen;
Tempern der Struktur, um einen Teil der dotierten amorphen Gebiete ausgehend von dem einkristallinen Körpergebiet (54) neu aufzuwachsen, um aktivierte Einkristall-Source- und Drain-Gebiete (56, 58) zu bilden; und
Bilden metallischer Kontakte (62, 64) in Kontakt mit den aktivierten Source- und Drain-Gebieten (56, 58) durch Ersetzen der restlichen Teile der dotierten amorphen Gebiete der Halbleiterschicht (6) durch Metall, wobei das Ersetzen umfasst:
Entfernen der restlichen Teile der dotierten amorphen Gebiete der Halbleiterschicht (6) unter Verwendung eines selektiven Ätzens, wobei das selektive Ätzen die dotierten amorphen Gebiete der Halbleiterschicht (6) selektiv entfernt, ohne die aktivierten Einkristall-Source- und Drain-Gebiete (56, 58) zu entfernen; und anschließend
Abscheiden der metallischen Kontakte (38, 40).

2. Verfahren nach Anspruch 1, wobei der Schritt des Temperns der Struktur zum Neuaufwachsen eines Teils der dotierten amorphen Gebiete ausgehend von dem einkristallinen Körpergebiet bei einer Temperatur von 500 °C bis 750 °C ausgeführt wird.

3. Verfahren nach Anspruch 1 oder Anspruch 2, wobei das Implantieren eines amorphisierenden Implantierungsstoffes und eines Dotierungsstoffes umfasst:
Implantieren eines amorphisierenden Implantierungsstoffes in die Halbleiterschicht (6); gefolgt von einem
Implantieren eines Dotierungsstoffes in die Halbleiterschicht (6).

4. Verfahren nach Anspruch 3, wobei das Implantieren eines amorphisierenden Implantierungsstoffes in die Halbleiterschicht (6) bei einer Neigung zwischen 5° und 30° ausgeführt wird.

5. Verfahren nach irgendeinem der Ansprüche 1 bis 4, wobei der Temperschritt für eine Zeitspanne zum Neuaufwachsen einer Strecke von 3 nm bis 10 nm des aktivierten Einkristall-Source-Gebiets (56) und des aktivierten Einkristall-Drain-Gebiets (58) ausgeführt wird.

## Revendications

1. Procédé de fabrication d'un transistor, le procédé comprenant :
la fourniture d'un semi-conducteur sur un substrat isolant ayant une couche de semi-conducteur (6) au-dessus de l'isolant (4) ;
la définition d'une grille supérieure isolée (8) au-dessus de la couche de semi-conducteur (6) ;
l'implantation d'un implant rendant amorphe et dopant pour créer des régions amorphes et dopées dans la couche de semi-conducteur à l'exception des endroits où la couche de semi-conducteur (6) est protégée par la grille (8), laissant ainsi une région de corps monocristallin (54) sous la grille supérieure isolée (8) ;
le recuit de la structure pour la recroissance d'une partie des régions amorphes dopées à partir de la région de corps monocristallin (54) pour former des régions de source et de drain monocristallines activées (56, 58) ; et
la formation de contacts métalliques (62, 64) en contact avec les régions de source et de drain activées (56, 58) par remplacement des parties restantes des régions amorphes dopées de la couche de semi-conducteur (6) par du métal, dans lequel ledit remplacement comporte :
une élimination des parties restantes des régions amorphes dopées de la couche de semi-conducteur (6) à l'aide d'une gravure sélective, dans laquelle ladite gravure sélective élimine de manière sélective les parties amorphes dopées de la couche de semi-conducteur (6) sans éliminer les régions de source et de drain monocristallines activées (56, 58) ; et ensuite
le dépôt desdits contacts métalliques (38, 40).

2. Procédé selon la revendication 1, dans lequel l'étape de recuit de la structure pour la recroissance d'une partie des régions amorphes dopées à partir de la région de corps monocristalline est menée à une température allant de 500°C à 750°C.

3. Procédé selon la revendication 1 ou la revendication 2, dans lequel ladite implantation d'un implant rendant amorphe et dopant comporte :
l'implantation d'un implant rendant amorphe dans la couche de semi-conducteur (6) ; suivie par
l'implantation d'un dopant dans la couche de semi-conducteur (6).

4. Procédé selon la revendication 3, dans lequel ladite implantation de l'implant rendant amorphe dans la couche de semi-conducteur (6) est effectuée avec un basculement de 5° à 30°.

5. Procédé selon l'une quelconque des revendications 1 à 4, dans lequel l'étape de recuit est effectuée pendant une durée permettant une recroissance de 3 nm à 10 nm de la région de source monocristalline activée (56) et de la région de drain monocristalline activée (58).
